Europäisches Patentamt

**European Patent Office**

**Office européen des brevets**

(11) Veröffentlichungsnummer: **0 308 628**

**A2**

# EUROPÄISCHE PATENTANMELDUNG

(21) Anmeldenummer: 88112427.5

(22) Anmeldetag: 01.08.88

(51) Int. Cl.⁴: **H03G 3/00 , H03G 3/04**

(30) Priorität: 19.09.87 DE 3731643

(43) Veröffentlichungstag der Anmeldung:
**29.03.89 Patentblatt 89/13**

(84) Benannte Vertragsstaaten:
**AT BE CH DE ES FR GB GR IT LI LU NL SE**

(71) Anmelder: **Deutsche Thomson-Brandt GmbH**
**Hermann-Schwer-Strasse 3 Postfach 1307**
**D-7730 Villingen-Schwenningen(DE)**

(72) Erfinder: **Schmitz, Friedrich**
**Sebastian-Kneipp-Strasse 24**
**D-7730 Villingen-Schwenningen(DE)**

(54) **Schaltungsanordnung zur Pegeleinstellung von Audiosignalen.**

(57)
2.1 Bei der Pegeleinstellung von Audiosignalen mit Hilfe von C-MOS-Schaltern (Multiplexern) entstehen während des Einstellvorgangs Knackgeräusche, die durch kapazitive Verkopplungen der digitalen Ansteuersignale in den Nutzsignalpfad einstreuen.

2.2 Um diese Störgeräusche zu vermeiden, wird das Nutzsignal dem Eingang eines gleichartig aufgebauten C-MOS-Schalters zugeführt. Das Nutzsignal wird an diesen Eingang jedoch über einen Inverter gegenphasig gelegt. Die Ausgänge der beiden C-MOS-Schalter sind, gegebenenfalls über Verstärkerstufen, an je einen Eingang eines Differenzverstärkers geschaltet. Am Ausgang dieses Differenzverstärkers entsteht ein von Knackgeräuschen freies Nutzsignal, da nur die Störgeräusche kompensiert werden.

2.3 Audioverstärker.

Fig.1

EP 0 308 628 A2

## Schaltungsanordnung zur Pegeleinstellung von Audiosignalen

Die Erfindung betrifft eine Schaltungsanordnung zur Pegeleinstellung von Audiosignalen unter Verwendung von C-MOS-Schaltern mit einer Wiederstandkette zur Unterteilung einer einem Audioverstärker zugeführten Eingangsspannung und mit digital ansteuerbaren Eingängen zur stufenweisen Durchschaltung der Abgriffe der Widerstandkette an den Ausgang des C-MOS-Schalters.

Eine derartige mit MOS-FET- oder C-MOS-FET-Schaltern aufgebaute Anordnung ist bekannt und wird z.B. zur Einstellung der Lautstärke in Audioverstärkern benutzt. Durch eine kaskadenförmige Reihenschaltung derartiger Anordnungen kann man eine grob- und feinstufige Einstellung z.B. eine Pegeleinstellung von 0 bis -110 db erreichen, die in Schritten von beliebiger Weite, z.B. von zwei db erfolgt. Die verwendeten C-MOS-Schalter haben jedoch eine nachteilige Eigenschaft, die darin besteht, daß deutlich hörbare Knackgeräusche während der Pegeländerung entstehen. Die Ausbildung derartiger Geräusche hat verschiedene Gründe. Die in integrierter Schaltungstechnik aufgebauten C-MOS-Schalter bestehen aus z.B. im BCD-Code ansteuerbare Feldeffekttransistoren (FET), die zwischen dem angesteuerten Gate und der Source-Drain-Strecke eine nicht vermeidbare kapazitive Verkopplung besitzen. Ebenfalls beinhalten diese Schalter Kapazitäten zwischen der Logik, die den Ansteuer-Code in einen Dezimal-Code dekodiert. Bei drei Eingängen handelt es sich z.B. um eine 1-aus-8-Logik oder bei zwei Eingängen um eine 1-aus-4-Logik. Auch bestehen Verkopplungen in Form von unerwünschten Kapazitäten zwischen der Betriebsspannungsschiene und Masse auf den Signalpfad. Bei der schrittweisen Pegelverstellung entstehen jeweils Nadelimpulse in der Größe der Betriebsspannung der Schalter. Wenn die zeitliche Dauer dieser Nadelimpulse auch nur im Mikrosekundenbereich liegt, so werden diese durch die Tiefpasswirkung des Audioverstärkers sowie durch die Physiologie des menschlichen Ohres integriert zu einem deutlichen Knacken bei jedem Schritt einer Änderung hörbar.

Der Erfindung liegt die Aufgabe zugrunde, die in der einleitenden Beschreibung definierte Schaltung von diesen störenden Knackgeräuschen zu befreien. Diese Aufgabe wird durch die im Patentanspruch 1 angegebene Erfindung gelöst. Weitere vorteilhafte Ausgestaltungen der Erfindung ergeben sich aus den Unteransprüchen.

Nachstehend wird die Erfindung mit Hilfe der Zeichnung erläutert.

Figur 1 zeigt ein erstes Ausführungsbeispiel

Figur 2 zeigt ein zweites Ausführungsbeispiel und

Figur 3 zeigt ein drittes Ausführungsbeispiel der Erfindung.

Das zu verstärkende und einzustellende Eingangssignal Ue wird dem Eingang E eines Operationsverstärkers OP1 zugeführt, an dessen Ausgang 01 über einen Koppelkondensator CK1 die Widerstandskette RK1 gegen Masse geschaltet ist. Die Abgriffe dieser Widerstandskette RK1 führen an die Eingänge e1,1 bis e1,8 der C-MOS-Schaltung IC1. Diese besitzt z.B. drei Steuereingänge A, B und C, die im BCD-Code die Eingänge e1,1 bis e1,8 nacheinander an den Ausgang a1 schalten. Über einen Koppelkondensator CK2 gelangt das am Ausgang a1 abgegriffene Signal über den Operationsverstärker OP2 an dessen Ausgang 02. Die bisher beschriebene Schaltung ist bekannt. Bedingt durch die oben geschilderten kapazitiven Verkopplungen entstehen am Ausgang 02 des Operationsverstärkers OP2 ausser dem Nutzsignal auch noch die störenden Nadelimpulse.

Nachfolgend wird die Schaltungsergänzung zur Lösung der der Erfindung zugrunde liegenden Aufgabe beschrieben.

Parallel zur C-MOS-Schaltung IC1 ist eine zweite C-MOS-Schaltung IC2 angeordnet. Diese ist an ihren Eingängen e2,1 bis e2,8 ebenfalls mit einer mit RK2 bezeichneten Widerstandskette beschaltet. Das am Ausgang 01 des Operationsverstärkers OP1 abgenommene Ausgangssignal gelangt über eine Inverterstufe INV und den Koppelkondensator CK3 an den Eingang e2,1 des C-MOS-Schalters IC2. Am Ausgang a2 wird das Signal über den Koppelkondensator CK4 an den Eingang eines Operationsverstärkers OP3 geschaltet. Die Steuereingänge A, B und C des C-MOS-Schalters IC2 liegen parallel zu den Steuereingängen A, B, C des C-MOS-Schalters IC1. Der Ausgang 02 des Operationsverstärkers OP2 und der Ausgang 03 des Operationsverstärkers OP3 sind auf je einen Eingang eines Differenzverstärkers OP4 geschaltet, an dessen Ausgang 04 das störbefreite Nutzsignal Ua abnehmbar ist. Die Wirkung der beschriebenen Schaltung erklärt sich dadurch, daß die Störimpulse aus den Schaltungen IC1 und IC2 durch die gleichzeitige und gleiche Digitalansteuerung an den Eingängen A, B und C synchron und phasengleich entstehen. Diese Störimpulse werden durch den Differenzverstärker OP4 kompensiert und erscheinen nicht am Ausgang 04. Der Differenzverstärker OP4 läßt dagegen das Nutzsignal unbeeinflusst, da es gegenphasig auf die Eingänge gelangt. Durch die Parallelschaltung zweier Verstärker ergibt sich darüberhinaus noch eine Verbesserung des Störabstandes von mindestens 3 db.

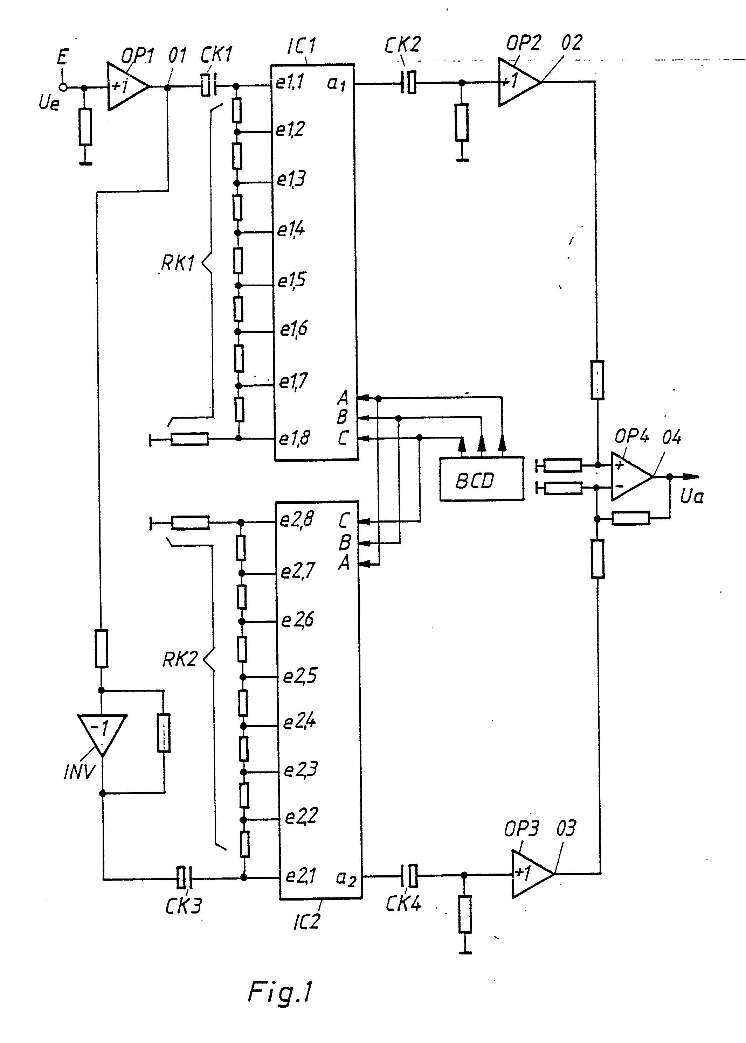

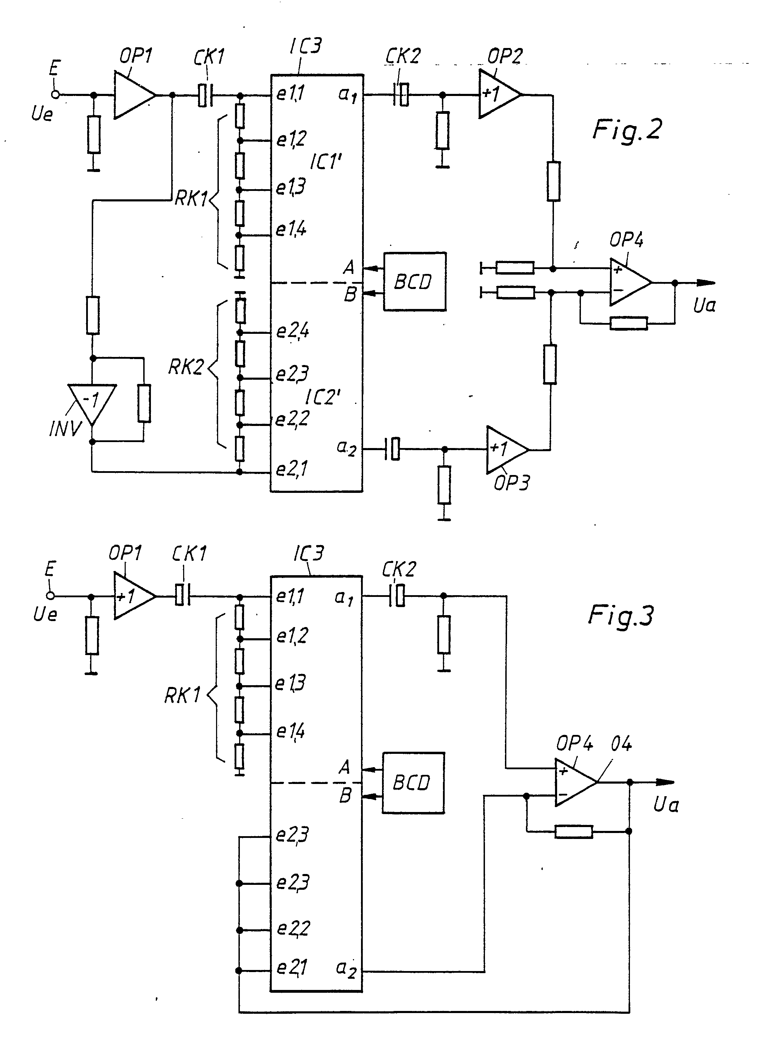

Die Kompensation der Störung ist nur dann optimal, wenn die Schaltungen IC1 und IC2 genau die gleiche Störgröße erzeugen. Dies ist jedoch nicht immer gewährleistet, wenn die Schaltungen z.B. aus sehr unterschiedlichen Chargen oder von unterschiedlichen Herstellern stammen. Eine verbesserte Version der Erfindung ergibt sich deshalb, wenn die beiden Schaltungen IC1 und IC2 auf ein und demselben Chip angeordnet sind. Diese Schaltung zeigt Figur 2, in welcher die gleichen Bezeichnungen der Figur 1 verwendet sind. In dem Beispiel ist eine Schaltung IC3 gezeigt, die zwei Steuereingänge A und B besitzt und die Widerstandskette RK1 und RK2 zwischen den Eingängen e1,1 bis e1,4 und e2,1 bis e2,4 aus je vier Wiederständen. besteht. Durch kaskadenartige Reihenschaltung derartiger Schaltungen kann man den gleichen Umfang der Pegeleinstellung erhalten.

In Figur 3 ist noch eine weitere Möglichkeit dargestellt, um die genannten Störimpulse zu eliminieren. Während die obere Hälfte der Figur 3 der vorangehenden Figur 2 entspricht, verbinden in der unteren Hälfte die Eingänge e2,1 bis e2,4 den Ausgang 04 des Operationsverstärkers OP4 über a2 mit seinem invertierenden Eingang. Hierbei gelangt das Nutzsignal unter Verzicht auf einen besseren Störabstand nur an einen Eingang des Differenzverstärkers OP4 unter Einsparung von Operationsverstärkern OP2, OP3 und der Inverterstufe INV.

Für die mit IC1,IC2 und IC3 bezeichneten C-MOS-Schalter seien die Typen MC 4051, 4o52, 14052 und 14097 beispielsweise genannt, die von unterschiedlichen Herstellern angeboten werden.

## Ansprüche

1. Schaltungsanordnung zur Pegeleinstellung von Audiosignalen unter Verwendung von C-MOS-Schaltern mit einer Widerstandskette zur Unterteilung einer einem Audioverstärker zugeführten Eingangsspannung und mit digital ansteuerbaren Eingängen zur stufenweisen Durchschaltung der Abgriffe der Widerstandskette an den Ausgang des C-MOS-Schalters, **dadurch gekennzeichnet,** daß ein zweiter C-MOS-Schalter (IC2) vorgesehen ist, der dem ersten C-MOS-Schalter (IC1) mit seinen Steuereingängen (A, B, C) sowie mit seinem Eingang (e2,1) parallelgeschaltet ist, und daß die Ausgänge (a1, a2) der beiden C-MOS-Schalter (IC1, IC2) an je einen Eingang eines Differenzverstärkers (OP4) geschaltet sind, an dessen Ausgang (04) das Nutzsignal abnehmbar ist.

2. Schaltungsanordnung nach Anspruch 1, **dadurch gekennzeichnet,** daß der zweite C-MOS-Schalter (IC2) an seinen Eingängen (e2,1-e2,8) ebenfalls mit einer Widerstandskette (RK2) versehen ist, an die das Eingangssignal des ersten C-MOS-Schalters (IC1) über eine Inverterstufe (INV) zugeführt ist.

3. Schaltungsanordnung nach Anspruch 1 oder 2, **dadurch gekennzeichnet,** daß die beiden C-MOS-Schalter (IC1, IC2) in einer einzigen integrierten Schaltung zusammengefasst sind.

4. Schaltungsanordnung nach Anspruch 1, **dadurch gekennzeichnet,** daß der zweite C-MOS-Schalter (IC2) den Ausgang (04) des Differenzverstärkers (OP4) mit seinem nichtinvertierenden Eingang verbindet.

Fig.1

V87/024

Fig.2

Fig.3